(19) Europäisches Patentamt
European Patent Office
Office européen des brevets

(11) EP 2 063 471 B1

(12) **EUROPEAN PATENT SPECIFICATION**

(45) Date of publication and mention of the grant of the patent:
**03.10.2012 Bulletin 2012/40**

(51) Int Cl.:
***H01L 51/05*** *(2006.01)*

(21) Application number: **07121569.3**

(22) Date of filing: **26.11.2007**

# (54) Organic field effect transistor

Organischer Feldeffekttransistor

Transistor à effet de champ organique

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**27.05.2009 Bulletin 2009/22**

(73) Proprietor: **Hitachi Ltd.**
**Tokyo (JP)**

(72) Inventors:
- **Nakako, Hideo**
  **Tsukuba-shi,**
  **Ibaraki-ken (JP)**
- **Yamamoto, Kazunori**
  **Tsukuba-shi,**
  **Ibaraki-ken (JP)**
- **Kumashiro, Yasushi**
  **Tsukuba-shi,**
  **Ibaraki (JP)**
- **Ando, Masahiko**
  **Hitachi-shi,**
  **Ibaraki-ken (JP)**
- **Shiba, Takeo**
  **c/o Hitachi, Ltd**
  **6-1 Marunouchi 1-chome,**
  **Chioda-ku**
  **Tokyo 100-8220 (JP)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(56) References cited:
**US-A1- 2006 006 380** **US-A1- 2006 202 288**
**US-A1- 2007 129 473** **US-A1- 2007 181 873**

- **HAAS U ET AL: "Hybrid polymers as tunable and directly-patternable gate dielectrics in organic thin-film transistors" PHYSICAL REVIEW. B, CONDENSED MATTER AND MATERIALS PHYSICS, AMERICAN INSTITUTE OF PHYSICS, WOODBURY, NY, US, vol. 73, no. 23, 21 June 2006 (2006-06-21), pages 235339-1, XP007904019 ISSN: 1098-0121**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 063 471 B1

## Description

The present invention relates to an organic field-effect transistor and to a method of fabricating an organic field-effect transistor.

Flat-panel displays, electronic paper, radio frequency identification tags, environmental sensors and some other forms of electronic device employ thin film transistors as switching elements.

Currently, thin film transistors are fabricated from amorphous or polycrystalline silicon using a variety of well-established semiconductor processing techniques, such as photolithography, chemical vapour deposition and laser annealing. However, these processes have a number of disadvantages. For example, the processes tend to be expensive, consume large amounts of power and/or suffer from low production yields. Furthermore, at least some of these processes require the use of substrates which are capable of being subjected to elevated temperatures (e.g. > 300 °C).

Thin film transistors fabricated from organic semiconductors and gate insulating materials offer advantages in that they use cheaper processing techniques, such as coating and printing, which are carried out at lower temperatures (e.g. < 200 °C). Thus, transistors can be formed on flexible substrates and yield devices which are lighter, flexible and more resilient to mechanical shock.

Attention is being directed to finding organic semiconductors with higher values of mobility ($\mu$), which helps to increase switching speed. However, the choice of material used for the gate insulating layer also influences performance. Therefore, efforts are being made to find materials having desirable gate dielectric properties, such as high resistivity (e.g. > $1 \times 10^{15}$ $\Omega$cm at 50 V), high breakdown voltage (e.g. > 5 $MVcm^{-1}$) and low hysteresis (e.g. exhibiting a shift in the turn-on voltage, $V_{th}$, greater than 1 V when cycled from $|V_{th}|$ to $|V_{th}$ + 20 V for 1000 s), as well as having favourable processing characteristics, such as being solution processable and curable at a low temperature (e.g. < 200 °C).

Existing gate dielectric materials tend to fall short in respect of at least one of these requirements.

Polyimides are commonly used as dielectrics in organic devices. However, most polyimides require high curing temperatures, above 200 °C, and so are unsuitable for use with many plastic substrates. Although pre-converted soluble polyimides may be used to achieve a lower curing temperature, these usually have a low solubility and so cannot be used to fabricate films thicker than about 1 $\mu$m which are usually necessary for organic transistors to operate at high voltages (e.g. > 50 V).

Epoxy resins have been used as insulators in a wide variety of applications such as in printed circuit boards and as sealing agent in integrated circuit packages. A photo-cured epoxy resin has been used as a gate insulating layer in a Si-FET as described in "A printable form of silicon for high performance thin film transistors on plastic substrates", E. Menard, K. J. Lee, D.-Y. Khang, R. G. Nuzzo, and J. A. Rogers, Applied Physics Letters, vol. 84, Num. 26, pages 5398 to 5400.

Divinyl-siloxane-bis-benzocyclobutene (BCB) is also used as a dielectric in organic devices and can be applied by spin-coating. However, BCB needs to be cured at high temperatures in an inert atmosphere.

Polymethylmethacrylates (PMMAs) have also been used as dielectrics in organic devices. However, PMMAs tend to have low glass transition temperatures and also tend to dissolve easily in other organic solvents used during device processing.

A phenol-based or phenol-derivative-based epoxy resin can also be used as a dielectric. Such an example is disclosed in US 2006/0006380. An epoxy resin can be applied as a solution and cured at low temperatures. However, FETs formed using this type of epoxy resin suffer from poor electrical properties, such as significant hysteresis.

Recently, a poly(vinylphenol) has been used as a gate dielectric because it has a high dielectric constant. However, the material suffers from low solubility and exhibits significant hysteresis. Moreover, when used with pentacene, the device exhibits low mobility. For example, all-polymer logic circuits have been made using poly(vinylphenol), as described in "Printable Organic and Polymeric Semiconducting Materials and Devices", Zhenan Bao, John A. Rogers and Howard E. Katz, Journal of Materials Chemistry, vol. 9, pages 1895 to 1904 (1999). However, these devices exhibit current-voltage characteristics which change significantly with time.

The present invention seeks to provide an organic field-effect transistor.

According to a first aspect of the present invention there is provided an organic field-effect transistor having a gate insulating layer comprising a cured epoxy resin, wherein the cured epoxy resin is substantially free of hydroxyl groups, and wherein the organic field-effect transistor exhibits, in a current-gate voltage transfer characteristic, a hysteretic shift in turn-on voltage of less than 1 V in magnitude.

The cured epoxy resin of the first aspect of the present invention may comprise silyl groups. The cured epoxy resin may comprise halo-methyl groups or fluoro-alkyl groups, such as trifluoromethyl groups. For the purposes of the present invention, the term "halo-methyl" encompasses methyl groups substituted with one, two or three halogens independently selected from fluorine, chlorine, bromine and iodine. The term "fluoro-alkyl" encompasses alkyl groups (preferably $C_{1-6}$ alkyl groups) substituted with one, two, three or more fluorines.

According to a second aspect of the present invention there is provided an organic field-effect transistor having a gate insulating layer comprising a cured epoxy resin, wherein the cured epoxy resin comprises halo-methyl groups or

fluoro-alkyl groups, and wherein the organic field-effect transistor exhibits, in a current-gate voltage transfer characteristic, a hysteretic shift in turn-on voltage of less than 1 V in magnitude.

The cured epoxy resin of the second aspect of the present invention may comprise silyl groups. The cured epoxy resin may be substantially free of hydroxyl groups. The cured epoxy resin may comprise trifluoromethyl groups.

The organic field-effect transistor may exhibit a hysteretic shift in turn-on voltage of less than 0.5 V in magnitude or less than 0.2 V in magnitude.

The organic field-effect transistor may comprise an organic semiconductor layer which comprises pentacene.

The first and second aspect of the present invention may provide an organic field-effect transistor having a gate insulating layer comprising a cured epoxy resin comprising silyl groups and/or trifluoromethyl groups.

The transistor may have a bottom gate, top electrode configuration or a top gate, bottom electrode configuration.

According to a third aspect of the present invention there is provided a method of fabricating an organic field-effect transistor according to the first or second aspect of the invention, the method comprising depositing an epoxy resin on a substrate, wherein the organic field-effect transistor exhibits, in a current-gate voltage transfer characteristic, a hysteretic shift in turn-on voltage of less than 1 V in magnitude.

Depositing the epoxy resin on a substrate may comprise spin-coating the epoxy resin on the substrate.

The method may comprise curing an epoxy component using a silyl-substituted hardener. The silyl-substituted hardener may be an alcohol or a phenol derivative substituted with a silyl group. The silyl group may comprise $R_3Si$, $R_2Si$ or RSi, where R is a phenyl, alkyl or alkyl siloxane group.

The method may comprise curing an epoxy component using a fluoro-alkyl-substituted hardener. The fluoro-alkyl-substituted hardener may comprise trifluoromethyl groups as the pendant groups.

The method may comprise curing a fluoro-alkyl-substituted epoxy component with a hardener. The fluoro-alkyl-substituted epoxy component may comprise trifluoromethyl groups. The trifluoromethyl-substituted epoxy component may comprise 4,4'-(hexafluoroisopropylidene)diphenol epoxy.

In one embodiment of the third aspect of the present invention there is provided a method of fabricating an organic field-effect transistor, the method comprising depositing an epoxy resin on a substrate, wherein the epoxy resin comprises an epoxy component and a silyl-substituted hardener.

In a further embodiment of the third aspect of the present invention there is provided a method of fabricating an organic field-effect transistor, the method comprising depositing an epoxy resin on a substrate, wherein the epoxy resin comprises an epoxy component and a trifluoromethyl-substituted hardener.

In another embodiment of the third aspect of the present invention there is provided method of fabricating an organic field-effect transistor, the method comprising depositing an epoxy resin on a substrate, wherein the epoxy resin comprises a trifluoromethyl-substituted epoxy component and a hardener.

Embodiments of the present invention will now be described, by way of example, with reference to the accompanying drawings in which:

Figure 1 is a perspective view of an organic field-effect transistor in accordance with the present invention;
Figure 1a is a schematic diagram of an interface between a gate insulating layer and an organic semiconductor layer of the organic field-effect transistor shown in Figure 1;
Figure 2 is a cross section of the organic field-effect transistor shown in Figure 1 taken along a line A-A';
Figure 3 is a plan view of the organic field-effect transistor shown in Figure 1;
Figures 4a to 4d illustrate fabrication of the field-effect transistor shown in Figure 1;
Figure 5 illustrates a testing circuit and an organic field-effect transistor under test;
Figure 6 are plots of source-drain voltage and gate voltage to determine hysteretic behaviour; and
Figures 7a to 7f are plots of source-drain current against gate bias for some embodiments of the present invention and comparative examples.

*Structure*

Referring to Figures 1, 2 and 3, an organic field-effect transistor (FET) 1 in accordance with the present invention is shown. The FET 1 has a "bottom-gate, top-electrode" configuration and comprises a gate 2 provided by a p-type silicon (Si) substrate, an inorganic gate insulating layer 3 comprising silicon dioxide ($SiO_2$) and having a thickness of 100 nm, an organic gate insulating layer 4 comprising an epoxy resin having a low concentration of trapping centres 8 (Figure 1a), an organic semiconductor layer 5, which in this example comprises (p-type) pentacene, and source and drain contacts 6, 7 comprising gold (Au). More than one organic gate insulating layer may be used.

Referring to Figure 1a, the epoxy resin has a lower concentration of trapping centres 8 in a surface region 9 at its interface 10 with the organic semiconductor layer 5 compared with a conventional epoxy resin in which trapping centres are provided by hydroxyl (OH) groups. The lower concentration of trapping centres 8 is thought to be achieved by reducing the number of hydroxyl groups throughout the layer 4 and/or by reducing the number of hydroxyl groups in

the surface region 9.

In some embodiments of the present invention, the epoxy resin is formed by curing an epoxy component using a silyl-substituted hardener or a trifluoromethyl-substituted hardener. In the former case, an epoxy group and a silyl group form a silyl ether group instead of a hydroxyl group. In the later case, trifluoromethyl groups aggregate in the surface region 9 due to differences in affinity between these groups and the rest of the polymer and, thus, force hydroxyl groups away from the interface 10, out of the surface region 9.

The epoxy component can be any reagent having epoxy groups, for example having a structure:

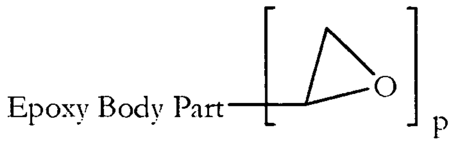

$2 \leq p \leq 1000$

Formula 1

Preferred epoxy components are bisphenol A-type epoxy, bisphenol AD-type epoxy, bisphenol F-type epoxy and noborac-type epoxy.

The silyl-substituted hardener may be an alcohol or a phenol derivative substituted with a silyl group, such as $R_3Si$, $R_2Si$, RSi, where R is a phenyl, alkyl or alkyl siloxane group, for example having a structure:

HO-Hardener-Body Part-$X_m$-OH

Formula 2

wherein $1 \leq m \leq 500$ and each repeating unit X is independently:

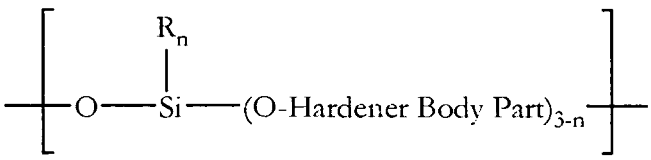

,

wherein n = 0-3.

A preferred silyl-substituted hardener is the silicone based phenolic resin having the structure (wherein $1 \leq m \leq 500$):

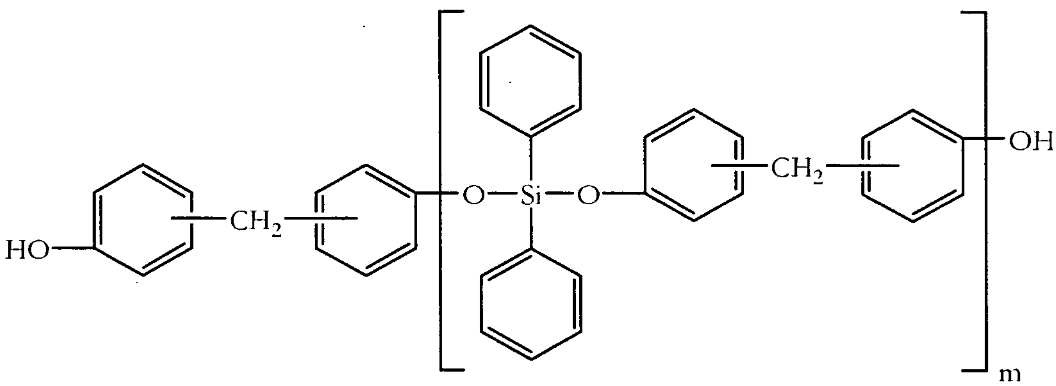

Formula 3

By curing an epoxy component with this silicone based phenolic hardener, the following hardened epoxy resin may be formed:

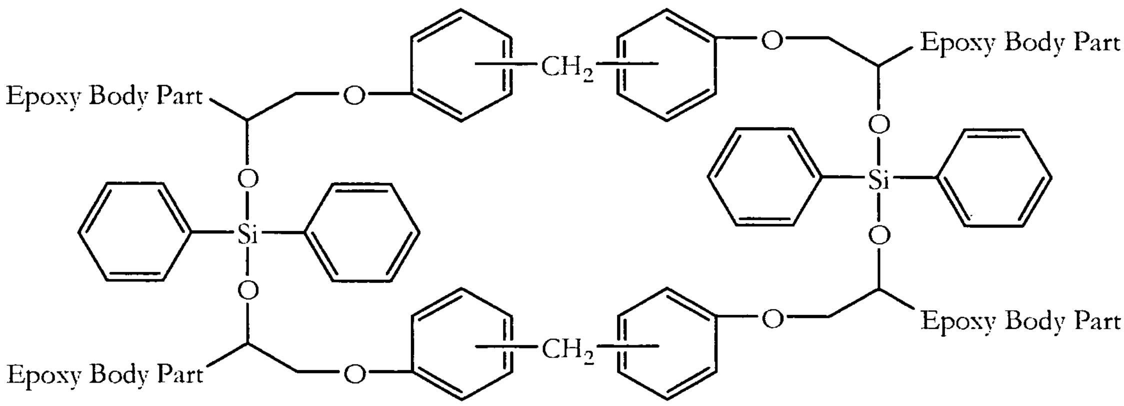

Formula 4

The trifluoromethyl-substituted hardener may be any component having trifluoromethyl group(s) as the pendant group(s), for example having a structure:

$$(OH)_n \text{ - Hardener Body Part-}(CF_3)_m$$

$2 \leq n \leq 1000$, and $1 \leq m \leq 1000$

Formula 5

A preferred trifluoromethyl-substituted hardener is 4,4'-(hexafluoroisopropylidene) diphenol having the structure:

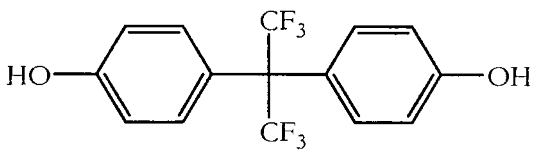

Formula 6

By curing an epoxy component with 4,4'-(hexafluoroisopropylidene)diphenol hardener, the following hardened epoxy resin may be formed:

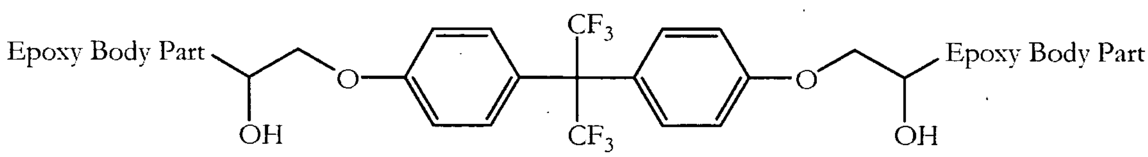

Formula 7

A catalyst can be used for the curing, such as an imidazole, amine or Lewis acid.

In other embodiments of the present invention, the epoxy resin is formed by curing a trifluoromethyl-substituted epoxy component with a hardener. In this case, the hardener can be any agent capable of reacting with and forming linkages with epoxy groups of the epoxy component, typically having two phenolic hydroxyl groups in a molecule, such

as a bisphenol A-type reagent, a bisphenol AD-type reagent, a bisphenol F-type reagent or a phenol derivative. However, the hardener may be a silyl-substituted hardener or a trifluoromethyl-substituted hardener. The trifluoromethyl-substituted epoxy may be any epoxy having trifluoromethyl group(s) as the pendant group(s), such as 4,4'-(hexafluoroisopropylidene) diphenol epoxy. A catalyst can be used for the curing, such as an imidazole, amine or Lewis acid.

*Fabrication*

Embodiments of FETs in accordance with the present invention and FETs used as comparative examples were fabricated using commercially-available materials, as will now be described:

Bisphenol-A noborac type epoxy (N865) and bisphenol-A noborac (VH-4170) were obtained from Dainippon Ink and Chemicals, Inc.

4,4'-(Hexafluoroisopropylidene)diphenol, 2-ethyl-4-methyl-imidazole (2E4MZ), anhydrous anisole and anhydrous 1-methyl-2-pyrrolidinone were obtained from Sigma-Aldrich Chemistry Co.

Silyl-substituted hardener, oligomer(diphenylsiloxane-co-bis-(4-hydroxyphenyl)methane), was synthesized in Hitachi Chemical Ltd. from bisphenol F and diphenyl dimethoxy silane.

Pentacene was obtained from Sigma-Aldrich Chemistry Co. and was used without further purification.

Referring to Figure 4a, 2-inch, thermally-oxidized, high-conductivity p-type silicon wafers 11 (hereinafter referred to as "thermally-oxidized silicon substrates") were obtained from KN plats Ltd.

The thermally-oxidized silicon substrates 11 comprise a surface layer 2 of $SiO_2$ having a thickness of 100 nm on highly-doped p-type silicon 3 having a conductivity of 0.002-0.004 $\Omega$cm. Chromium-coated silicon wafers (not shown) were also obtained from KN plats Ltd. The chromium wafers comprised a silicon wafer and evaporated surface layer of chromium having a thickness of 20 nm.

<u>First embodiment</u>

Referring to Figures 4a to 4d, a first embodiment of an FET in accordance with the present invention was fabricated by a method which will now be described.

Bisphenol-A noborac type epoxy N865, silyl-substituted hardener, anisole, and 1-methyl-2-pyrrolidinone were weighed, put in a sample tube and dissolved by shaking in a clean room. 2-Ethyl-4-methyl-imidazole (2E4MZ) solution in anisole, 0.1phr, is added to the solution. Weights are in Table I, below:

Table I

| | First embodiment | Second embodiment | Comparative example |
|---|---|---|---|
| Epoxy | N865 | N865 | N865 |
| Amount (g) | 1.77 | 1.68 | 1.68 |
| Hardener | Silyl-substituted hardener | 4,4'-(Hexafluoro isopropylidene) diphenol | Bisphenol-A noborac |
| OH/epoxy | 1 | 1 | 1 |
| Amount (g) | 1.23 | 1.99 | 0.92 |
| Catalyst | 2E4MZ | 2E4MZ | 2E4MZ |
| Conc. in resin (phr) | 0.1 | 0.1 | 0.1 |
| Amount of 1% sol. (g) | 0.30 | 0.37 | 0.26 |
| Solvent 1 | Anisole | Anisole | Anisole |
| Amount (g) | 11.7 | 15.5 | 12.0 |
| Solvent 2 | 1-Methyl-2-pyrrolidinone | 1-Methyl-2-pyrrolidinone | 1-Methyl-2-pyrrolidinone |
| Amount (g) | 5.0 | 6.7 | 5.1 |
| Solvent 1/Solvent 2 | 7/3 | 7/3 | 7/3 |
| Conc. of resin (mass %) | 15 | 14 | 13 |

The solution was filtered through a membrane filter with 0.02 m pores, Anotop 10 (Whatman Ltd.), just before spin coating. The solution was spin-coated on a thermally-oxidized silicon wafer in a $N_2$ glove box by two-step spinning, in particular 500 rpm for 5 s and 2000 rpm for 60 s to form a coated substrate. The coated substrate was dried at 100 °C for 10 min and cured at 200 °C for 60 min on a hot plate in a $N_2$ glove box. The resulting structure is shown in Figure 4b.

Pentacene and the source and drain electrodes were evaporated using a thermal deposition system (Kurt J.

Lesker Company Ltd.) in a $N_2$ glove box (not shown). Thickness and deposition rate were monitored by a quartz crystal oscillator.

Pentacene was deposited through a metal mask (not shown) at a rate of 0.4 Å/s to a thickness of 60 nm. The resulting structure is shown in Figure 4c.

The source and drain electrodes were formed by evaporating gold through a different metal mask (not shown) at a rate of 0.4 Å/s to a thickness of 20 nm. The resulting structure is shown in Figure 4d.

Referring again to Figures 1 to 3, the FET 1 has a channel width, W, of 1 mm and a channel length, L, of 5 mm.

<u>Second embodiment</u>

A second embodiment of an FET in accordance with the present invention was made using the same method used to fabricate the first embodiment, except that a different hardener was used. In particular, 4,4'-(hexafluoroisopropylidene)diphenol was used as hardener instead of the silyl-substituted hardener.

<u>First comparative example</u>

A first comparative example of an FET was made using the same method used to fabricate the first embodiment of an FET according to the invention, except that a different, conventional hardener was used. In particular, VH-4170 was used as hardener in place of the silyl-substituted hardener.

<u>Second comparative example</u>

A second comparative example of an FET was made using the same method used to fabricate the first embodiment of an FET according to the invention, except that a first type of conventional organic dielectric was used.

Divinyl-siloxane-bis-benzocyclobutene (Dow Chemical Company) (30 mass %) was diluted to 1.9 mass % with mesitylene and filtered through a membrane filter to provide a diluted solution. The diluted solution was spin-coated on a thermally-oxidized silicon wafer with a rotation speed 2000 rpm for 40 s in a $N_2$ glove box to provide a coated wafer. The coated wafer was cured at 290 °C for 1 min on a hot plate in the $N_2$ glove box.

After curing, a layer of pentacene was deposited and the source and drain electrodes were defined as described earlier.

<u>Third comparative example</u>

A third comparative example of an FET was made using the same method used to fabricate the first embodiment of an FET according to the invention, except that a second type of conventional dielectric was used.

Poly(4-vinylphenol) 0.02g and 1,6-bis(trichlorosilyl)hexane 0.02g were mixed with tetrahydrofuran 9.6g. The solution was filtered through a membrane filter with 0.02 m pores, Anotop 10 (Whatman Ltd.), just before spin coating. The solution was spin-coated on a thermally-oxidized silicon wafer in a $N_2$ glove box by two-step spinning, in particular at 500 rpm for 5 s and 2000 rpm for 60 s to provide a coated substrate. The coated substrate was cured at 200 °C for 60 min on a hot plate in the $N_2$ glove box.

After curing, a layer of pentacene was deposited and the source and drain electrodes were defined as described earlier.

<u>Fourth comparative example</u>

A fourth comparative example of an FET was made using the same method used to fabricate the first embodiment of an FET according to the invention, except that a third type of conventional organic dielectric was used.

A thermally-oxidized silicon wafer was treated with 1,1,1,3,3,3-hexamethyldisilazane vapour on a glass holder in a glass bottle attached with a water condenser and a hot plate set at 170 - 180 °C.

After curing, a layer of pentacene was deposited and the source and drain electrodes were defined as described earlier.

*Measurements*

The embodiments of FETs according to the present invention and the FETs used as comparative examples were characterised using the following measurements.

Polymer thickness

Values for the thickness of the hardened epoxy resins were obtained using a surface profile measuring device (Dektak) (not shown) by measuring a scratch made by a sharp knife.

Surface morphology

Surface morphologies of the hardened epoxy resin and the deposited pentacene were observed using atomic force microscope (AFM) (not shown).

Surface energy

Values of surface energy for the polymer surface were calculated by Van Oss model from the contact angles measured by optical contact angle and surface tension meter (CAM200, KSV Instruments Ltd.) (not shown) with three probe liquid, water, formamide and glycerol.

Breakdown voltage and leak current

Values of break down voltage and resistivity were obtained from I-V curves measured using a Model 237 High-Voltage Source-Measure Unit (Keithley Instruments Ltd.) (not shown) and test samples comprising a layer of dielectric sandwiched between electrodes.

The test samples were fabricated on chromium-coated substrate (not shown) which provided a back electrode. Different dielectrics were deposited on different substrates (not shown) using the same processes described earlier and gold discs (not shown) having a diameter of 1 mm were evaporated through a shadow mask so as to provide top electrodes.

A needle probe station (not shown) was used to make contact with the electrodes and measurements of break down voltage, resistivity and dielectric constant were made, in air, at room temperature.

Threshold voltage and mobility

Referring to Figure 5, measurements of hysteresis and mobility of the FETs 12 were carried out with a probe station (not shown) placed in a $N_2$ glove box and a semiconductor parameter analyzer 13 (4155B, Agilent Ltd.). Common parameters for the parameter analyzer were a gate voltage ($V_G$) step of 0.5 V and source voltage ($V_S$) of-10 V.

Mobility and threshold voltage were calculated using equation 1 below using values of slope and intercept taken from plots (not shown) of the square root of current, $I_D$, against gate voltages, $V_G$:

$$(I_D)^{1/2} = \left(\frac{1}{2}\frac{W}{L}\mu C\right)^{1/2} V_G - \left(\frac{1}{2}\frac{W}{L}\mu C\right)^{1/2} V_{th} \qquad (1)$$

$$\mu = (\text{slope})^2 \frac{2L}{CW} \qquad (2)$$

$$V_{th} = \frac{(\text{intercept})}{-1\times\left(\frac{1}{2}\frac{W}{L}\mu C\right)^{1/2}} \qquad (3)$$

where $\mu$ is mobility, $V_{th}$ is threshold voltage, $I_D$ is source-drain current, $V_G$ is gate voltage and C is capacitance calculated using $C = \varepsilon\varepsilon_0(A/d)$, where A is the area of the pentacene layer 5 (Figure 3) and d is the thickness of the dielectric layers 3, 4 (Figure 2). A ratio of the channel length (L) and the channel width (W) were obtained from optical micrographs of the FETs.

Hysteresis property ($V_{th}$ shift)

Hysteretic properties were measured using values of $V_{th}$ before and after a gate bias, $V_G$ = - 1 ( | $V_{th}$|+20) V is applied. The gate bias is a function of the threshold voltage, $V_{th}$, measured for each transistor.

Referring to Figure 6, a plot 14 of source voltage $V_S$ and a plot 15 of gate voltage $V_G$ applied during a testing cycle are shown. Thus, the source voltage $V_S$ is ramped from 0 V to - 1 (| $V_{th}$| +20) V over a period of 60 s while a constant gate voltage $V_G$ = -10 V is applied. Once the source voltage $V_S$ has reached - 1 (| $V_{th}$| +20) V, the gate bias, $V_G$, is removed.

Results of the measurements are shown in Table II below:

Table II

| FET | Thickness of gate dielectric (nm) | Pentacene grain size (nm) | FET Properties | | | |
|---|---|---|---|---|---|---|
| | | | $V_{th}$ shift (V) | Mobility ($cm^2V^{-1}s^{-1}$) | $\lvert V_{th}\rvert$ (V) | $I_{ON}/I_{OFF}$ |
| 1st embodiment | 370 | 0.9 | -0.6 | 0.13 | 11 | $10^5$ |
| 2nd embodiment | 289 | 1.0 | -0.2 | 0.14 | 8 | $10^5$ |
| 1st comparative example | 380 | 1.3 | -2.9 | 0.14 | 8 | $10^5$ |
| 2nd comparative example | 128 | 0.2 | -8 | 0.17 | 3 | $10^5$ |
| 3rd comparative example | 138 | - | +1.4 | 0.06 | 15 | $10^3$ |
| 4th comparative example | 300 | 0.9 | -1.1 | 0.14 | -1.0 | $10^6$ |

It is noted that in the first and second embodiments of the invention and the first, second and third comparative examples, the dielectric is spin-coated on a thermally-oxidized silicon wafer. In the fourth comparative example, the dielectric is deposited by vapour deposition on a thermally-oxidized silicon wafer.

Values of breakdown voltage and resistivity are shown in Table III below:

Table III

| FET | Breakdown field (MV/cm) | Resistivity ($10^5\Omega cm$) |
|---|---|---|
| First embodiment | 5 | 1.3 |
| Second embodiment | 5 | 0.6 |
| First comparative example | 5 | 0.12 |
| Second comparative example | 5 | - |

Referring to Figures 7a to 7f, transfer characteristics (or "transfer curves") illustrate hysteretic behaviour of the first and second embodiments of FETs in accordance with the present invention and the first, second, third and fourth FETs used as comparative examples.

It will be appreciated that many modifications may be made to the embodiments hereinbefore described whilst remaining within the scope of the claims.

Other hydroxyl protecting groups, for example an ester group such as $-COCH_3$, can be used to mask hydroxyl groups. Other suitable hydroxyl protecting groups are described, for example, in "Protective Groups in Organic Synthesis" by T.W. Greene and P.G.M. Wuts (Wiley-Interscience, 3rd edition, 1999).

Other halo-methyl groups, such as trichloromethyl groups, or other fluoro-alkyl groups, such as trifluoroethyl or pentafluoroethyl groups, may be used instead of the trifluoromethyl groups in the trifluoromethyl-substituted hardener or the trifluoromethyl-substituted epoxy component.

Other device configurations may be employed. For example, instead of a top contact configuration, a bottom-contact configuration may be used in which the organic semiconductor layer is deposited over source and drain contacts. Examples of device configurations can be found in US-B-6 433 359.

Other substrates may be used, such as glass or polycarbonate.

Other inorganic dielectrics may be used, such as $Si_3N_4$. The inorganic dielectric layer may be omitted.
Other organic semiconductors may be used. For example, other semiconducting oligomers may be used, such as anthracene or rubrene. A semiconducting polymer may be used such as poly(3-hexylthiophene), poly(p-phenylene vinylene) or poly(9,9'-dioctylfluorene-co-benzothiadiazole) ("F8BT"). The organic semiconductor may be p-type or n-type.
Other source and drain contact materials may be used, such as conducting polymers.
Other layer thicknesses and device geometries may be used.

## Claims

1. An organic field-effect transistor having a gate insulating layer comprising a cured epoxy resin, **characterised in that** the cured epoxy resin is substantially free of hydroxyl groups, and wherein the organic field-effect transistor exhibits, in a current-gate voltage transfer characteristic, a hysteretic shift in turn-on voltage of less than 1 V in magnitude.

2. An organic field-effect transistor according to claim 1, wherein the cured epoxy resin comprises silyl groups.

3. An organic field-effect transistor according to claim 1 or 2, wherein the cured epoxy resin comprises an ester group.

4. An organic field-effect transistor having a gate insulating layer comprising a cured epoxy resin, **characterised in that** the cured epoxy resin comprises halo-methyl groups or fluoro-alkyl groups, and wherein the organic field-effect transistor exhibits, in a current-gate voltage transfer characteristic, a hysteretic shift in turn-on voltage of less than 1 V in magnitude.

5. An organic field-effect transistor according to claim 4, wherein the cured epoxy resin comprises trifluoromethyl groups.

6. An organic field-effect transistor according to any one of claims 1 to 5, which exhibits a hysteretic shift in turn-on voltage of less than 0.5 V in magnitude.

7. An organic field-effect transistor according to any one of claims 1 to 6, which exhibits a hysteretic shift in turn-on voltage of less than 0.2 V in magnitude.

8. An organic field-effect transistor according to any one of claims 1 to 7, comprising an organic semiconductor layer which comprises pentacene.

9. An organic field-effect transistor according to any one of claims 1 to 8, wherein the transistor has a bottom gate, top electrode configuration.

10. An organic field-effect transistor according to any one of claims 1 to 8, wherein the transistor has a top gate, bottom electrode configuration.

11. A method of fabricating an organic field-effect transistor according to any one of claims 1 to 10, the method comprising depositing an epoxy resin on a substrate.

12. A method according to claim 11, wherein depositing the epoxy resin on a substrate comprises spin-coating the epoxy resin on the substrate.

13. A method according to claim 11 or 12, comprising.

    curing an epoxy component using a silyl-substituted hardener.

14. A method according to claim 13, wherein the silyl-substituted hardener is an alcohol or a phenol derivative substituted with a silyl group.

15. A method according to claim 14, wherein the silyl group comprises $R_3Si$, $R_2Si$ or RSi, where R is a phenyl, alkyl or alkyl siloxane group.

16. A method according to claim 11 or 12, comprising:

curing an epoxy component using a fluoro-alkyl-substituted hardener.

**17.** A method according to claim 16, wherein the fluoro-alkyl-substituted hardener comprises trifluoromethyl groups as the pendant groups.

**18.** A method according to claim 11 or 12, comprising:

curing a fluoro-alkyl-substituted epoxy component with a hardener.

**19.** A method according to claim 18, wherein the fluoro-alkyl-substituted epoxy component comprises trifluoromethyl groups.

**20.** A method according to claim 19, wherein the trifluoromethyl-substituted epoxy component comprises 4,4'-(hexafluoroisopropylidene)diphenol epoxy.

**Patentansprüche**

**1.** Organischer Feldeffekttransistor mit einer Gate-Isolatorschicht, umfassend ein gehärtetes Epoxidharz, **dadurch gekennzeichnet, dass** das gehärtete Epoxidharz im Wesentlichen frei von Hydroxylgruppen ist und wobei der organische Feldeffekttransistor in einer Strom-Gatespannungs-Kennlinie eine Hystereseverschiebung der Schaltspannung dem Betrage nach von weniger als 1 V aufweist.

**2.** Organischer Feldeffekttransistor nach Anspruch 1, wobei das gehärtete Epoxidharz Silylgruppen umfasst.

**3.** Organischer Feldeffekttransistor nach Anspruch 1 oder 2, wobei das gehärtete Epoxidharz eine Estergruppe umfasst.

**4.** Organischer Feldeffekttransistor mit einer Gate-Isolatorschicht, umfassend ein gehärtetes Epoxidharz, **dadurch gekennzeichnet, dass** das gehärtete Epoxidharz Halogenmethylgruppen oder Fluoralkylgruppen umfasst und wobei der organische Feldeffekttransistor in einer Strom-Gatespannungs-Kennlinie eine Hystereseverschiebung der Schaltspannung dem Betrage nach von weniger als 1 V aufweist.

**5.** Organischer Feldeffekttransistor nach Anspruch 4, wobei das gehärtete Epoxidharz Trifluormethylgruppen umfasst.

**6.** Organischer Feldeffekttransistor nach einem der Ansprüche 1 bis 5, welcher eine Hystereseverschiebung der Schaltspannung dem Betrage nach von weniger als 0,5 V aufweist.

**7.** Organischer Feldeffekttransistor nach einem der Ansprüche 1 bis 6, welcher eine Hystereseverschiebung der Schaltspannung dem Betrage nach von weniger als 0,2 V aufweist.

**8.** Organischer Feldeffekttransistor nach einem der Ansprüche 1 bis 7, umfassend eine organische Halbleiterschicht, welche Pentacen umfasst.

**9.** Organischer Feldeffekttransistor nach einem der Ansprüche 1 bis 8, wobei der Transistor eine Bottom-Gate-, Top-Elektroden-Konfiguration aufweist.

**10.** Organischer Feldeffekttransistor nach einem der Ansprüche 1 bis 8, wobei der Transistor eine Top-Gate-, Bottom-Elektroden-Konfiguration aufweist.

**11.** Verfahren zur Herstellung eines organischen Feldeffekttransistors nach einem der Ansprüche 1 bis 10, wobei das Verfahren das Aufbringen eines Epoxidharzes auf ein Substrat umfasst.

**12.** Verfahren nach Anspruch 11, wobei das Aufbringen des Epoxidharzes auf ein Substrat das Rotationsbeschichten des Epoxidharzes auf das Substrat umfasst.

**13.** Verfahren nach Anspruch 11 oder 12, umfassend:

Aushärten eines Epoxidbestandteils unter Verwendung eines silylsubstituierten Härtungsmittels.

**14.** Verfahren nach Anspruch 13, wobei das silylsubstituierte Härtungsmittel ein Alkohol oder ein mit einer Silylgruppe substituiertes Phenolderivat ist.

**15.** Verfahren nach Anspruch 14, wobei die Silylgruppe $R_3Si$, $R_2Si$ oder RSi umfasst, wobei R eine Phenyl-, Alkyl- oder Alkylsiloxangruppe ist.

**16.** Verfahren nach Anspruch 11 oder 12, umfassend:

Aushärten eines Epoxidbestandteils unter Verwendung eines fluoralkylsubstituierten Härtungsmittels.

**17.** Verfahren nach Anspruch 16, wobei das fluoralkylsubstituierte Härtungsmittel Trifluormethylgruppen als anhängende Gruppen umfasst.

**18.** Verfahren nach Anspruch 11 oder 12, umfassend:

Aushärten eines fluoralkylsubstituierten Epoxidbestandteils mit einem Härtungsmittel.

**19.** Verfahren nach Anspruch 18, wobei der fluoralkylsubstituierte Epoxidbestandteil Trifluormethylgruppen umfasst.

**20.** Verfahren nach Anspruch 19, wobei der trifluormethylsubstituierte Epoxidbestandteil 4,4‘-(Hexafluorisopropyliden) diphenolepoxid umfasst.

**Revendications**

**1.** Transistor à effet de champ organique, ayant une couche d’isolation de grille comprenant une résine époxy durcie, **caractérisé en ce que** la résine époxy durcie est substantiellement dépourvue de groupes hydroxyle, ledit transistor à effet de champ organique présentant, dans une caractéristique de transfert de tension de grille-courant, un déplacement hystérétique de tension de mise en marche inférieur à 1 V d’amplitude.

**2.** Transistor à effet de champ organique suivant la revendication 1, dans lequel la résine époxy durcie comprend des groupes silyle.

**3.** Transistor à effet de champ organique suivant la revendication 1 ou 2, dans lequel la résine époxy durcie comprend un groupe ester.

**4.** Transistor à effet de champ organique ayant une couche d’isolation de grille comprenant une résine époxy durcie, **caractérisé en ce que** la résine époxy durcie comprend des groupes halogénométhyle ou des groupes fluoralkyle, ledit transistor à effet de champ organique présentant, dans une caractéristique de transfert de tension de grille-courant, un déplacement hystérétique de tension de mise en marche inférieur à 1 V d’amplitude.

**5.** Transistor à effet de champ organique suivant la revendication 4, dans lequel la résine époxy durcie comprend des groupes trifluorométhyle.

**6.** Transistor à effet de champ organique suivant l’une quelconque des revendications 1 à 5, qui présente un déplacement hystérétique de tension de mise en marche inférieur à 0,5 V d’amplitude.

**7.** Transistor à effet de champ organique suivant l’une quelconque des revendications 1 à 6, qui présente un déplacement hystérétique de tension de mise en marche inférieur à 0,2 V d’amplitude.

**8.** Transistor à effet de champ organique suivant l’une quelconque des revendications 1 à 7, comprenant une couche semiconductrice organique qui comprend du pentacène.

**9.** Transistor à effet de champ organique suivant l’une quelconque des revendications 1 à 8, ledit transistor ayant une configuration grille inférieure, électrodes supérieures.

**10.** Transistor à effet de champ organique suivant l’une quelconque des revendications 1 à 8, ledit transistor ayant une configuration grille supérieure, électrodes inférieures.

**11.** Procédé de fabrication d'un transistor à effet de champ organique suivant l'une quelconque des revendications 1 à 10, le procédé comprenant le dépôt d'une résine époxy sur un substrat.

**12.** Procédé suivant la revendication 11, dans lequel le dépôt de la résine époxy sur un substrat comprend l'application par revêtement centrifuge de la résine époxy sur le substrat.

**13.** Procédé suivant la revendication 11 ou 12, comprenant :

le durcissement d'un constituant époxy en utilisant un durcisseur à substituant silyle.

**14.** Procédé suivant la revendication 13, dans lequel le durcisseur à substituant silyle est un alcool ou un dérivé phénolique substitué avec un groupe silyle.

**15.** Procédé suivant la revendication 14, dans lequel le groupe silyle comprend $R_3Si$, $R_2Si$ ou RSi, dans lequel R représente un groupe phényle, alkyle ou alkylsiloxane.

**16.** Procédé suivant la revendication 11 ou 12, comprenant :

le durcissement d'un constituant époxy en utilisant un durcisseur à substituant fluoralkyle.

**17.** Procédé suivant la revendication 16, dans lequel le durcisseur à substituant fluoralkyle comprend des groupes trifluorométhyle comme groupes appendus.

**18.** Procédé suivant la revendication 11 ou 12, comprenant :

le durcissement d'un constituant époxy à substituant fluoralkyle avec un durcisseur.

**19.** Procédé suivant la revendication 18, dans lequel le constituant époxy à substituant fluoralkyle comprend des groupes trifluorométhyle.

**20.** Procédé suivant la revendication 19, dans lequel le constituant époxy à substituant trifluorométhyle comprend un époxy 4,4'-(hexafluoro-isopropylidène)-diphénolique.

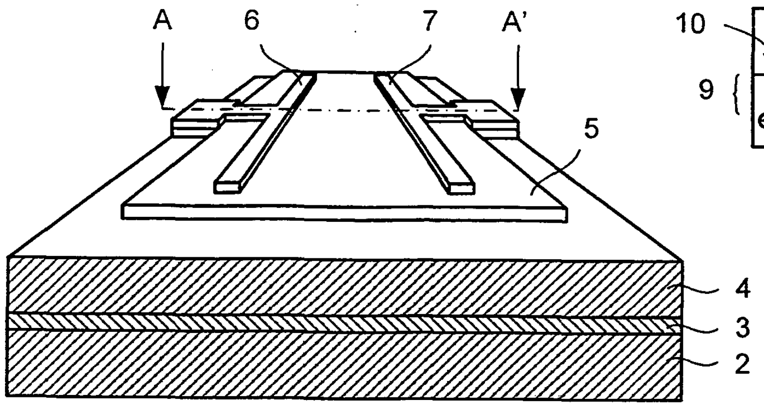


Fig. 1

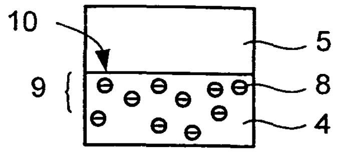


Fig. 1a

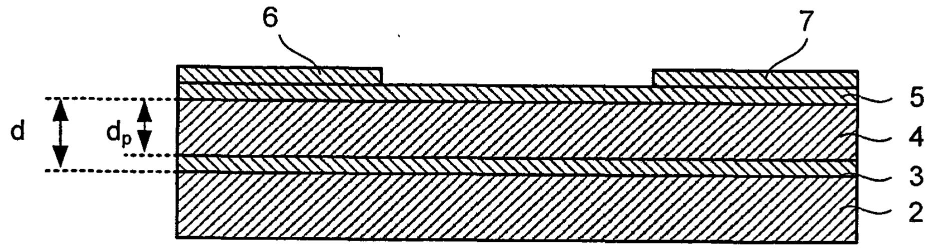


Fig. 2

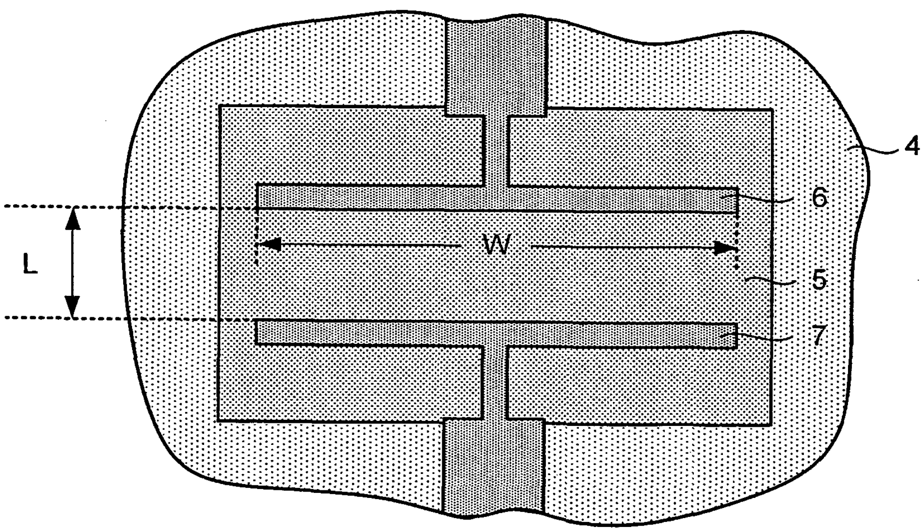


Fig. 3

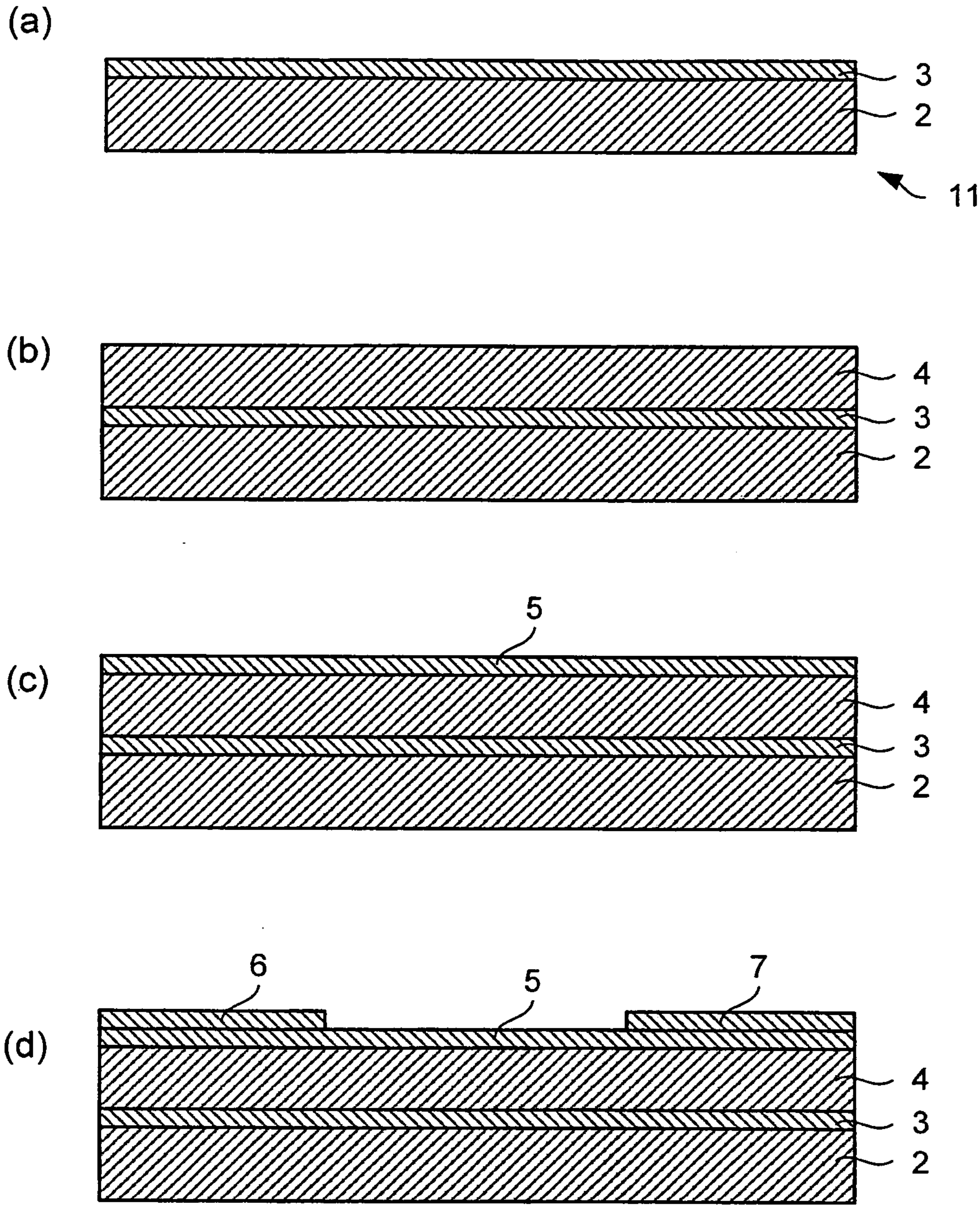


Fig. 4

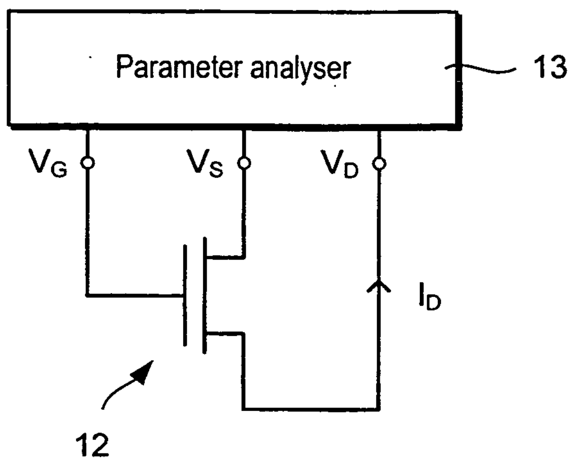
Parameter analyser
13
$V_G$
$V_S$
$V_D$
$I_D$
12

Fig. 5

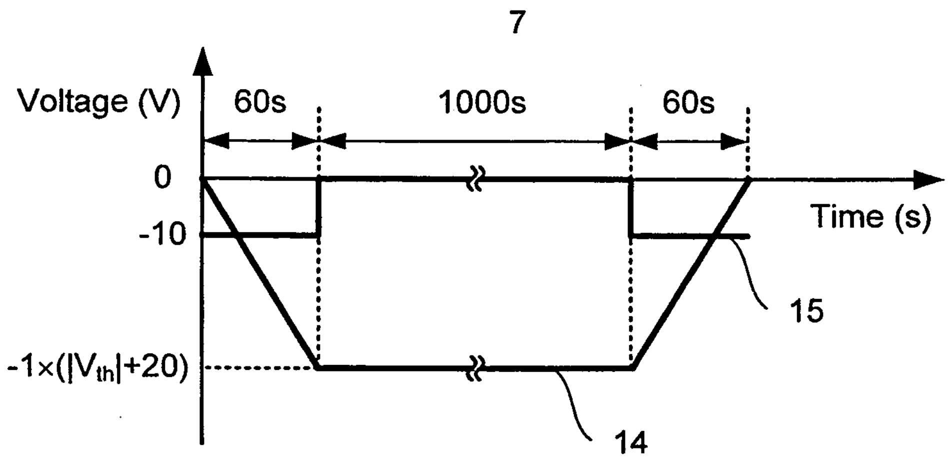
7
Voltage (V)
60s
1000s
60s
0
-10
Time (s)
15
-1×(|$V_{th}$|+20)
14

Fig. 6

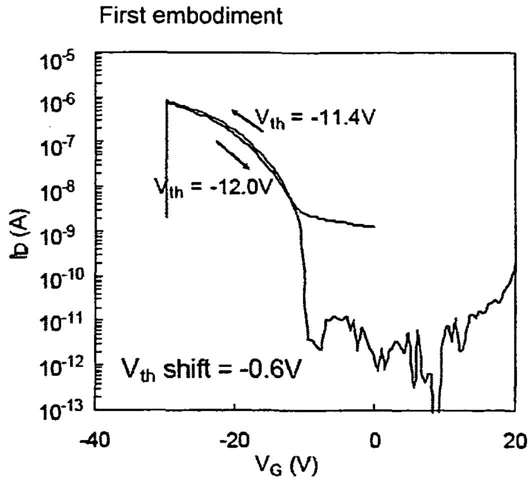


Fig. 7a

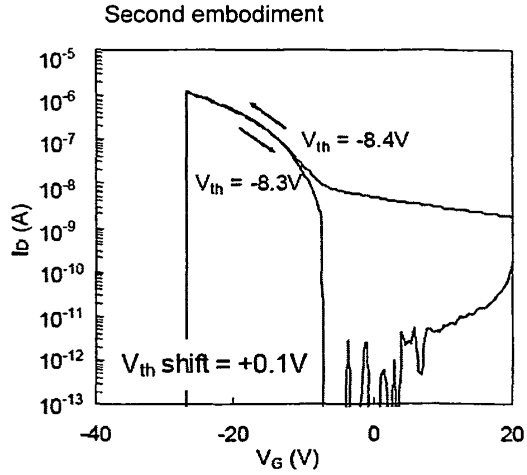


Fig. 7b

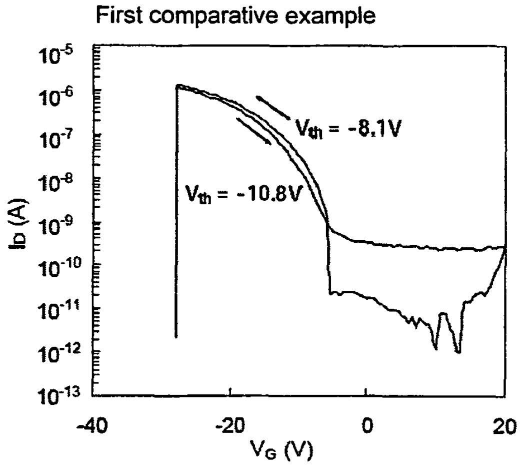


Fig. 7c

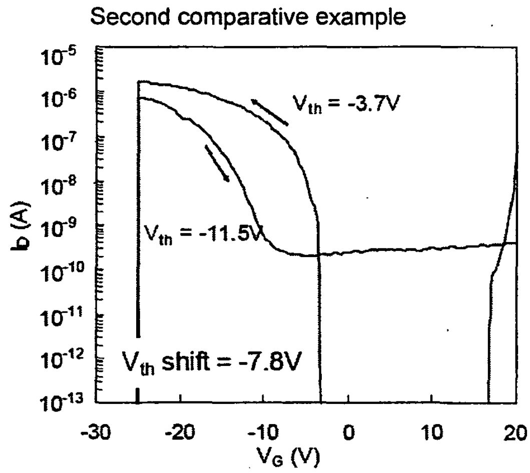


Fig. 7d

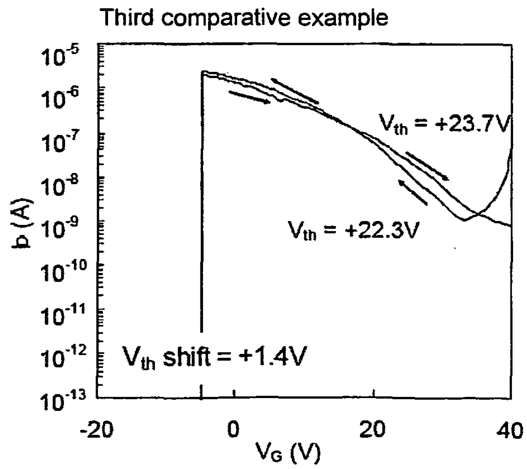


Fig. 7e

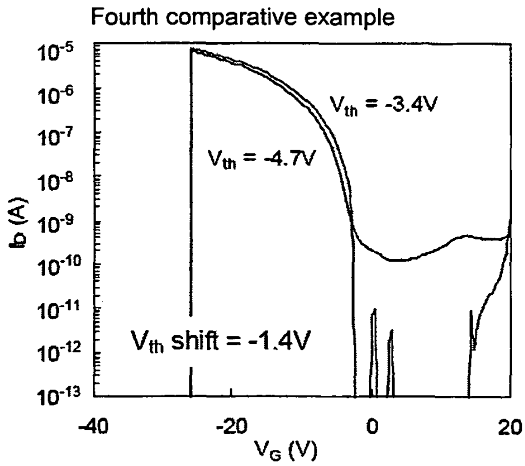


Fig. 7f

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20060006380 A
- US 6433359 B


### Non-patent literature cited in the description


- **E. MENARD ; K. J. LEE ; D.-Y. KHANG ; R. G. NUZZO ; J. A. ROGERS.** A printable form of silicon for high performance thin film transistors on plastic substrates. *Applied Physics Letters,* vol. 84 (26), 5398-5400
- **ZHENAN BAO ; JOHN A. ROGERS ; HOWARD E. KATZ.** Printable Organic and Polymeric Semiconducting Materials and Devices. *Journal of Materials Chemistry,* 1999, vol. 9, 1895-1904
- **T.W. GREENE ; P.G.M. WUTS.** Protective Groups in Organic Synthesis. Wiley-Interscience, 1999